# EUROPEAN PATENT SPECIFICATION

(11) **EP 0 591 900 B1**
(45) Date of publication and mention of the grant of the patent: **13.01.1999**
(21) Application number: 93116022.0
(22) Date of filing: 04.10.1993
(51) Int. Cl.: H01L 23/04, H01L 23/24, H01L 23/495

(54) **Resin-sealed semiconductor device**
In Harz versiegeltes Halbleiterbauelement
Dispositif à semiconducteur scellé dans de la résine

(30) Priority: 05.10.1992 JP 265222/92
(43) Date of publication of application: 13.04.1994
(73) Proprietor: FUJI ELECTRIC CO. LTD., Kawasaki 210 (JP)
(72) Inventor: Nagaune, Fumio, c/o Fuji Electric Co., Ltd., Kawasaki-ku, Kawasaki, 210 (JP); Matsushita, Hiroaki, c/o Fuji Electric Co., Ltd., Kawasaki-ku, Kawasaki, 210 (JP)
(74) Representative: Hoffmann, Eckart, Dipl.-Ing.

(56) References cited:
- EP-A- 0 112 512
- WO-A-91/15873
- DD-A- 141 736
- DE-A- 2 652 708
- US-A- 3 995 932
- US-A- 4 880 400
- PATENT ABSTRACTS OF JAPAN vol. 6, no. 72 (E-105) 7 May 1982 & JP-A-57 010 952 (MITSUBISHI ELECTRIC CORP)
- PATENT ABSTRACTS OF JAPAN vol. 14, no. 142 (E-0904) 16 March 1990 & JP-A-02 005 559 (FUJI ELECTRIC CO LTD) 10 January 1990
- PATENT ABSTRACTS OF JAPAN vol. 13, no. 346 (E-798) 3 August 1989 & JP-A-01 106 457 (MITSUBISHI ELECTRIC CORP)

## Description

The present invention relates to a resin-sealed semiconductor device, such as a diode, thyristor or transistor module, and, more particularly, to the structure of a terminal thereof used for connecting an external wiring to the device.

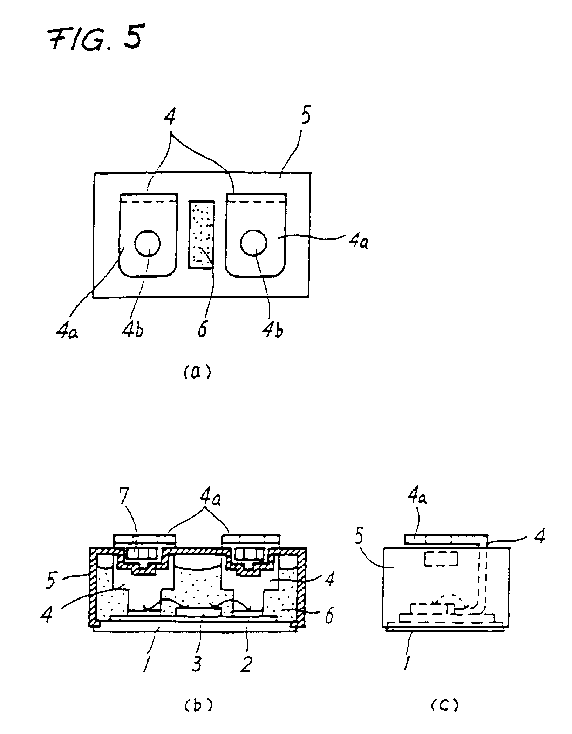

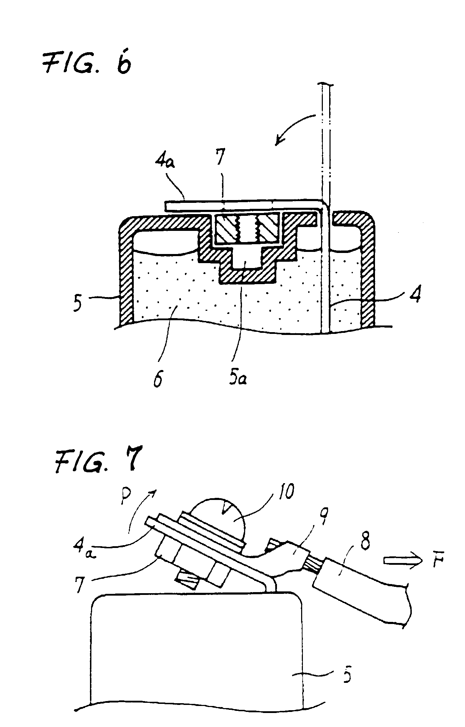

Figs. 5(a) to (c) and 6 show a conventional resin-sealed semiconductor device and its terminal structure. In the figure, numeral 1 represents a heat dissipating metal base, 2 an insulating substrate, 3 a semiconductor chip, 4 a terminal, 5 an outer casing made of resin, 6 a sealing compound such as epoxy resin that fills the casing, and 7 a terminal nut mounted in a respective recess 5a on top of the outer casing 5. The figures actually show two terminals 4, two nuts 7, two recesses 5a etc. the number depending on the kind of semiconductor device. For ease of explanation, in the following description of the prior art and the invention reference will be made to one terminal only and it goes without saying that the same applies to all terminals.

The terminal 4 comprises a lower part disposed inside the casing 5 and an upper part disposed outside the casing and forming a wiring connection portion 4a. The wiring connection portion 4a is bent to be substantially parallel to the top of the casing 5.

A semiconductor device with such a construction is assembled in the following manner. First, the semiconductor chip 3 and the terminal 4 which has not yet been bent at this stage are mounted via the insulating substrate 2 on the metal base 1 and electrically connected to each other, thereby to form a circuit assembly. Then, the casing 5 is placed on this circuit assembly, fixed to the metal base 1, and then filled with sealing compound 6 injected through an injection hole formed at the top of the casing 5. The sealing compound is then hardened to seal the circuit assembly. Thereafter, the terminal nut 7 is mounted in the recess 5a whose upper portion is a polygonal hole substantially complementary to the outer shape of the terminal nut and whose lower portion is provided for receiving the end of a fixing screw (10 in Fig. 7).

Then the upper part of the terminal 4 projecting out of the top side of the casing 5 is bent into an L shape from the straight line state indicated by the chain lines in Fig. 6 to the position shown by solid lines, thereby creating the external wiring connection portion 4a overlying the recess 5a and the terminal nut 7 disposed in it. The numeral 4b denotes a hole drilled in the wiring connection portion 4a where a fixing screw is to be inserted.

The conventional terminal construction described above has the following problems because of a lack of mechanical strength.

That is, the wiring connection portion 4a has a cantilever structure supported at one end only, namely at the bending or corner of the L shape. Therefore, when a large tensile external force shown by arrow F in Fig. 7, is imposed on an external wiring 8 having a connecting terminal metal part 9 fixed to the wiring connection portion 4a by means of a fixing screw 10 and the nut 7 as shown in Fig. 7, the wiring connection portion 4a is pulled in a direction indicated by an arrow P (turned clockwise in Fig. 7) and deformed as shown. This may happen to an extent that the wiring connection portion 4a is lifted with the nut 7 pulled out from the recess 5a. Moreover, if a repeated load such as a vibration is imposed on the semiconductor device for an extended period of time when such a deformation has been caused, stress will be concentrated on the bent part of the terminal 4 , leading to a breakage of the terminal at the bent part because of elastic fatigue, which in turn can cause a serious failure of the semiconductor device as it becomes impossible to energize it.

WO-A-91/15873 discloses a semiconductor device having an outer casing housing a semiconductor chip and filled with a sealing compound, several terminals bent into an L-shape of which one leg extends into the casing and is connected to the semiconductor chip while the other leg forms an external wiring connection portion disposed outside of the casing in parallel to a wall portion thereof, a recess formed in the wall portion beneath the wiring connection portion, and a terminal nut provided in the recess for connection of an external wiring to the wiring connection portion by means of a screw passing through a hole in the wiring connection portion and screwed into the terminal nut. The leg of the terminal extending into the casing is provided with recesses in which bosses or protruding portions forming part of the casing engage in a latching connection thereby blocking a vertical movement of the terminal leg extending vertically.

According to JP-A-57-010952 the bending of lead terminals and correspondingly the damage of semiconductor elements upon application of a bending force to the connection portion of the terminal is avoided by injecting a resin such that the terminal nut for connecting the terminal by means of a screw passing through a hole in the terminal wiring connection portion is buried.

US-A-3,995,932 discloses a convertible contact module for a relay including terminal straps which form closed loops at each end of the module housing. For this purpose the legs formed in the terminal straps are firmly anchored to the module housing. This anchoring is obtained by inserting the two end portions of the leg sidewardly into respective slots provided in the base portion of the two-part housing, whereafter a cover comprising two projecting portions, which engage in the slots of the base and a respective recess between the end portion and the legs, is fastened to the base. Thereby the terminal strap is blocked or anchored in the base by means of the protruding portions of the cover latching by engaging with the recesses adjacent the respective end portions.

The present invention has been made after considering these problems, with the intention of solving said problems, and its objective is to provide a terminal structure for such resin-sealed or potted semiconductor device with improved support strength against external forces acting on the external part of the terminal.

The above objective is achieved by a semiconductor device as claimed in claim 1; the features of the preamble are known in combination in the above-mentioned JP-A-57-010952.

Preferred embodiments of the invention are subject-matter of dependent claims.

In one embodiment of the invention an anchor that is bent downward is disposed on the tip of the terminal extending further from the external wiring connection portion, said anchor being fixed on the casing. The anchor may be fixed by inserting the tip of the anchor into the outer casing and embedding it in the sealing compound, or forming the tip of the anchor integrally with the outer casing by embedding it in the case lid that has been formed as a resin molding independent of the outer casing.

In another embodiment of the invention an auxiliary metal anchoring member is inserted between the terminal nut and the external wiring connection portion of the terminal, the leg of said auxiliary member being fixed on the outer casing. The auxiliary member may be fixed by inserting a leg of the auxiliary member into the outer casing and embedding it in the molded resin serving as sealing compound.

In the above embodiments, the external wiring connection portion of the terminal and the terminal nut, or the external wiring connection portion and the auxiliary metal anchoring member are bonded together by screwing the external wiring onto the wiring connection portion with a fixing screw. In each case the wiring connection portion is fixed to the casing at two points thereby increasing the strength of the support. Therefore, even if a large tensile external force is imposed on an external wiring connection portion of the terminal via the external wiring, undesirable deformation of the terminal and its floating away from the outer casing can be prevented, and trouble such as breakage of the terminal can be reliably prevented even if a repeated load such as a vibration is imposed.

Embodiments of the present invention are described below with reference to the accompanying schematic drawings, in which:
- Fig. 1 (a) to (c): illustrate a first embodiment of the invention with (a) being a fragmentary cross-sectional view of the semiconductor device, (b) being a perspective view of an upper part of the terminal and (c) showing a longitudinal section of the semiconductor device;
- Fig. 2: is a cross-sectional view similar to Fig. 1(a), illustrating the terminal structure corresponding to a second embodiment of the present invention;
- Figs. 3 (a) and (b): illustrate a third embodiment of the present invention, with (a) showing in cross section the upper part of the semiconductor device in an assembled condition, and (b) showing a perspective view of a metal anchoring member used in this embodiment;
- Figs. 4 (a) to (e): illustrate modifications of the metal anchoring member for use in the third embodiment of the invention;
- Figs. 5 (a) to (c): are a plan view, a longitudinal cross section and a side view, respectively, of a conventional resin-sealed semiconductor device;
- Fig. 6: is a cross section illustrating the terminal structure of the device shown in Fig. 5; and
- Fig. 7: illustrates a deformation of the terminal of the conventional semiconductor device of Figs. 5 and 6 when an external force acts on the terminal.

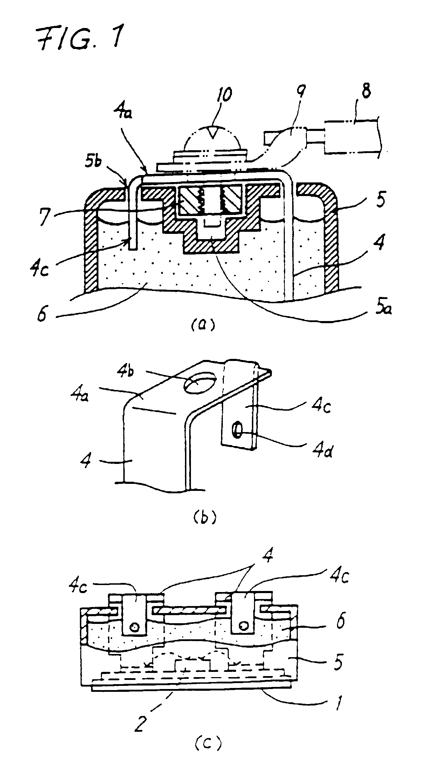

In Figs. 1 to 4 parts identical to those in Figs. 5 and 6 are given the same reference numerals.

### First embodiment:

Figs. 1 (a), (b) and (c) show a first embodiment of the invention which differs from the conventional device explained above mainly by having the terminal 4 equipped with a tongue-like anchor portion 4c formed and arranged to provide for a second support of the wiring connection portion 4a. The anchor portion 4c extends from the distal end of the wiring connection portion 4a, i.e. the end of the latter opposite to the end where it is bent from the lower part of the terminal 4. The anchor portion 4c is bent downward or back into the casing 5 through a hole 5b on the top of the outer casing 5. The free tip end of the anchor portion 4c is embedded and fixed in the sealing compound 6. Numeral 4d denotes an anchoring hole drilled at the tip of the anchor portion 4c.

The above structure is assembled in the following manner: After the circuit assembly is covered with the casing 5, the terminal 4 protruding from the top of the casing 5 is bent into an inverted U-shape with the wiring connection portion 4a forming the base of the U-shape and located outside of the casing 5 and the anchor portion 4c inserted into the casing 5. Then the sealing compound or resin 6 is injected into the casing 5 and hardened. Thus, the rising lower part of the terminal 4 and at least the tip end of the anchor portion 4c are embedded and fixed in the sealing compound 6. By providing an anchoring hole 4d in the anchor portion 4c, sealing compound 6 will flow through this anchoring hole 4d, thereby increasing the bonding strength. This allows the wiring connection portion to be supported at two opposite sides, thus assuring a high support strength, and preventing the problems of the conventional semiconductor device mentioned above.

### Second embodiment:

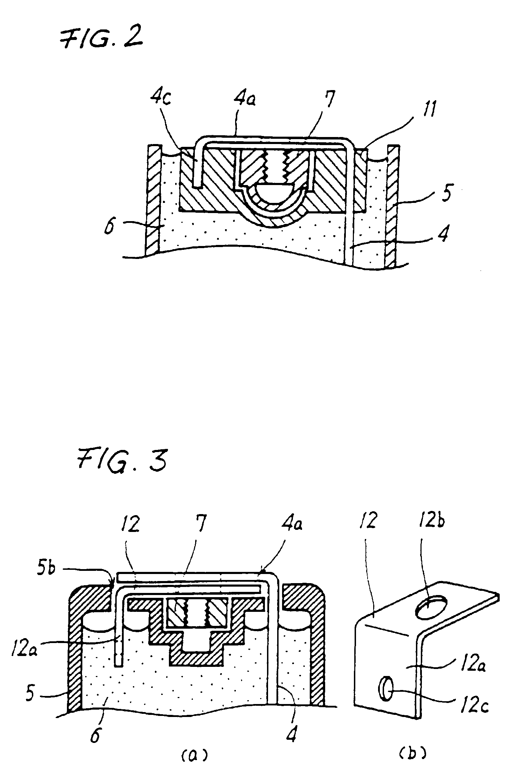

Fig. 2 shows a second embodiment of the present invention. In this embodiment, a case lid 11 made from resin separate from said casing 5 is provided on top of the casing. The terminal 4 has substantially the same structure as that of the first embodiment, however, in this case the upper part of the terminal 4 is formed integrally with the case lid such that, except for the wiring connection portion 4a, the upper part of the terminal 4 is embedded in the case lid 11. The case lid 11 is molded integrally with the terminal 4 and the terminal nut 7 before the terminal 4 is integrated into the circuit assembly and after the wiring connection portion 4a and the anchor portion 4c are bent and formed. A box nut is used as the terminal nut 7 to prevent resin from getting into the screw hole during the forming process. The terminal 4 now formed integrally with the case lid 11 is integrated into the circuit assembly, the circuit assembly covered with the casing 5 and the casing 5 filled with sealing compound 6, which is then hardened thereby securing the case lid 11 to the casing 5.

This construction improves the supporting strength of the terminal 4 to the same extent as that in the first embodiment described earlier. Moreover, such a construction makes it possible to bend the terminal 4 prior to integrating it into the circuit assembly, thus making the assembling efficiency higher than in the first embodiment.

### Third embodiment:

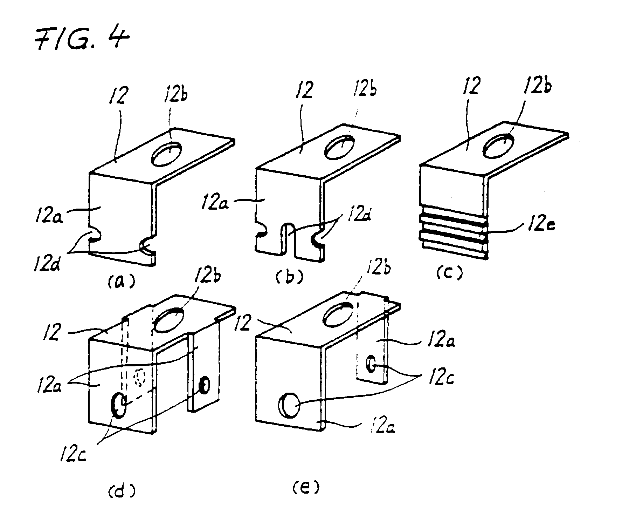

Fig. 3 shows a third embodiment of the present invention. In this embodiment a separate metal anchoring member 12 which is bent into an L shape is inserted between the wiring connection portion 4a and the terminal nut 7. A bent leg 12a of this member 12 is inserted into the casing through a hole 5b in the outer casing 5 at a position opposite to where the terminal 4 comes out of the casing 5 and is embedded and fixed in the sealing compound 6 therein. Numeral 12b is a screw hole provided in the horizontal leg of the anchoring member 12 at a position registered with the terminal nut 7, and numeral 12c is an anchoring hole drilled at the tip of the leg 12a.

When the terminal 4 of this embodiment is connected to an external wiring in the same manner as in Fig. 7, the terminal 4 and the anchoring member 12 are joined together by the fixing screw (10 in Fig. 7) and the nut 7. This construction, which the leg 12a of the member 12 embedded and fixed in the sealing compound 6, serves to reinforce the terminal 4 to the same extent as in the previously described embodiments. Furthermore, a spring seat provided on the member 12 serves to prevent the fixing screw screwed into the terminal nut 7 from becoming loose.

Figs. 4 (a) through (e) show variations of the metal anchoring member 12 of Fig. 3. Notches 12d providing an equivalent anchoring effect are formed in place of the anchoring hole 12c in Figs. 4 (a) and (b), while irregular steps 12e are formed in Fig. 4 (c), and plural legs 12a are formed in Figs. 4 (d) and (e), each leg being provided with an anchoring hole 12c.

By adopting a construction as in the above described embodiments of the present invention, the terminal can be reliably prevented from becoming excessively deformed and from being lifted off the outer casing, or from breaking due to a repeated load such as vibration, even if great external tensile force is applied to the external wiring screwed on the external wiring connection portion of the terminal. As a result, the product reliability can be greatly improved.

## Claims

1. A semiconductor device having an outer casing (5) housing a semiconductor chip (3) and filled with a sealing compound (6), at least one terminal (4) bent into an L-shape of which one leg extends into the casing (5) and is connected to the semiconductor chip (3) while the other leg forms an external wiring connection portion (4a) disposed outside of the casing (5) substantially in parallel to a wall portion thereof, a recess (5a) formed in said wall portion beneath the wiring connection portion (4a), and a terminal nut (7) provided in the recess (5a) for connection of an external wiring (8, 9) to the wiring connection portion (4a) by means of a screw (10) passing through a hole in the wiring connection portion (4a) and screwed into the terminal nut (7),
**characterized by** anchoring means (4c, 12) additionally fixing the wiring connection portion (4a) to the casing (5) at a position spaced apart from the corner of the L-shaped terminal (4),
said anchoring means (4c, 12) comprising a strip-shaped downwardly extending anchor portion (4c, 12a) inserted into the casing (5) and embedded in the sealing compound (6), said anchor portion (4c, 12a) being positioned opposite to said one leg of said terminal (4) with respect to said hole in said wiring connection portion (4a).

2. The semiconductor device of claim 1, wherein the anchor portion (4c) is an integral part of said terminal (4) provided at the end of the wiring connection portion (4a) opposite to said corner and is bent downward.

3. The semiconductor device of claim 2, wherein said wall portion of the casing (5) is formed by a case lid (11) formed as a separate resin molding and fixed to the casing (5) by means of the sealing compound (6), the tip of the anchor portion (4c) being integrally inserted into the case lid (11) instead of being embedded in said sealing compound (6).

4. The semiconductor device of claim 1, wherein said anchoring means comprises a separate anchoring member (12) which is substantially L-shaped with one leg inserted between the wiring connection portion (4a) and the terminal nut (7) and having a screw hole (12b) registered with the terminal nut (7), and the other leg (12a) forming said anchor portion fixing said anchoring member (12) to the casing (5).

## Patentansprüche

1. Halbleiterbauelement mit einem Außengehäuse (5), welches einen Halbleiterchip (3) beherbergt und mit einer Vergußmasse (6) gefüllt ist, wenigstens einem Anschluß (4), der in eine L-Form gebogen ist, deren einer Schenkel sich in das Gehäuse (5) erstreckt und mit dem Halbleiterchip (3) verbunden ist, während der andere Schenkel einen externen Verdrahtungsverbindungsabschnitt (4a) bildet, der außerhalb des Gehäuses (5) im wesentlichen parallel zu einem Wandabschnitt desselben angeordnet ist, einer Ausnehmung (5a), die in dem Wandabschnitt unterhalb des Verdrahtungsverbindungsabschnitts (4a) ausgebildet ist, und einer Anschlußmutter (7), die in der Ausnehmung (5a) zur Verbindung einer externen Verdrahtung (8, 9) mit dem Verdrahtungsverbindungsabschnitt (4a) mittels einer Schraube (10) vorgesehen ist, welche ein Loch in dem Verdrahtungsverbindungsabschnitt (4a) durchsetzt und in die Anschlußmutter (7) geschraubt ist,
**gekennzeichnet durch** Verankerungsmittel (4c, 12), die den Verdrahtungsverbindungsabschnitt (4a) an einer von der Ecke des L-förmigen Anschlusses (4) beabstandeten Position zusätzlich an dem Gehäuse (5) fixieren,
wobei die Verankerungsmittel (4c, 12) einen streifenförmigen, sich nach unten erstreckenden Ankerteil (4c, 12a) umfassen, der in das Gehäuse (5) eingesteckt und in der Vergußmasse (6) eingebettet ist, wobei der Ankerteil (4c, 12a) auf der dem einen Schenkel des Anschlusses (4) entgegengesetzten Seite des Lochs in dem Verdrahtungsverbindungsabschnitt (4a) positioniert ist.

2. Halbleiterbauelement nach Anspruch 1, bei dem der Ankerteil (4c) ein einstückiger Teil des Anschlusses (4) ist, der an dem der Ecke entgegengesetzten Ende des Verdrahtungsverbindungsabschnitts (4a) vorgesehen und nach unten gebogen ist.

3. Halbleiterbauelement nach Anspruch 2, bei dem der Wandabschnitt des Gehäuses (5) von einem Gehäusedeckel (11) gebildet ist, das als gesondertes Harzformteil ausgebildet und mittels der Vergußmasse (6) an dem Gehäuse (5) fixiert ist, wobei die Spitze des Ankerteils (4c) integral in den Gehäusedeckel (11) eingesetzt ist anstatt in der Vergußmasse (6) eingebettet zu sein.

4. Halbleiterbauelement nach Anspruch 1, bei dem die Verankerungsmittel ein gesondertes Verankerungsglied (12) umfassen, welches im wesentlichen L-förmig ist, wobei ein Schenkel zwischen dem Verdrahtungsverbindungsabschnitt (4a) und die Anschlußmutter (7) gesetzt ist und ein mit der Anschlußmutter (7) ausgerichtetes Schraubloch (12b) aufweist, während der andere Schenkel (12a), der den Ankerteil bildet, das Verankerungsglied (12) an dem Gehäuse (5) fixiert.

## Revendications

1. Dispositif à semi-conducteur ayant un boîtier (5) extérieur logeant une puce (3) à semi-conducteur et empli d'un composé (6) de scellement, au moins une borne (4) courbée en une forme de L dont une jambe s'étend dans le boîtier (5) et est reliée à la puce (3) à semi-conducteur, tandis que l'autre jambe forme une partie (4a) de connexion de fils extérieure disposée à l'extérieur du boîtier (5) sensiblement parallèlement à une de ses parois, un évidement (5a) formé dans la partie formant paroi au-delà de la partie (4a) de connexion de fils, et un écrou (7) de borne prévu dans l'évidement (5a) pour la connexion d'un fil (8, 9) extérieur à la partie (4a) de connexion de fils au moyen d'une vis (10) passant par un trou dans la partie (4a) de connexion de fils et vissée dans l'écrou (7) de borne,
caractérisé par des moyens (4c, 12) d'ancrage fixant de manière supplémentaire la partie (4a) de connexion de fils au boîtier (5) en une position à distance du coin de la borne (4) en forme de L,
les moyens (4c, 12) d'ancrage comportant une partie (4c, 12a) d'ancrage s'étendant vers le bas en forme de bande insérée dans le boîtier (5) et noyée dans le composé (6) de scellement, la partie (4c, 12a) d'ancrage étant positionnée opposée à ladite une jambe de la borne (4) par rapport au trou dans la partie (4a) de connexion de fils.

2. Dispositif à semi-conducteur suivant la revendication 1, dans lequel la partie (4c) d'ancrage est une partie d'une pièce avec la borne (4) prévue à l'extrémité de la partie (4a) de connexion de fils opposée au coin et est courbée vers le bas.

3. Dispositif à semi-conducteur suivant la revendication 2, dans lequel la partie paroi du boîtier (5) est formée par un couvercle (11) de boîtier formé en tant qu'un moule de résine distinct et fixé au boîtier (5) au moyen du composé (6) de scellement, la pointe de la partie (4c) d'ancrage étant d'une pièce insérée dans le couvercle (11) de boîtier au lieu d'être noyée dans le composé (6) de scellement.

4. Dispositif à semi-conducteur suivant la revendication 1, dans lequel les moyens d'ancrage comportent un élément (12) d'ancrage distinct qui a une forme sensiblement en L, une jambe étant insérée entre la partie (4a) de connexion de fils et l'écrou (7) de borne et ayant un trou (12b) de vis indiqué par l'écrou (7) de borne, et l'autre jambe (12a) formant la partie d'ancrage fixant l'élément (12) d'ancrage au boîtier (5).
